Europäisches Patentamt

European Patent Office

Office européen des brevets

(11) Veröffentlichungsnummer: **0 257 620 B1**

# (12) EUROPÄISCHE PATENTSCHRIFT

(45) Veröffentlichungstag der Patentschrift: **06.05.92**

(21) Anmeldenummer: **87112323.8**

(22) Anmeldetag: **25.08.87**

(51) Int. Cl.⁵: **H01L 31/18**, C23C 16/50

(54) Verfahren und Vorrichtung zum Ausbilden einer Schicht durch plasmachemischen Prozess.

(30) Priorität: **27.08.86 DE 3629000**

(43) Veröffentlichungstag der Anmeldung:
**02.03.88 Patentblatt 88/09**

(45) Bekanntmachung des Hinweises auf die
Patenterteilung:
**06.05.92 Patentblatt 92/19**

(84) Benannte Vertragsstaaten:
**DE ES FR IT**

(56) Entgegenhaltungen:
EP-A- 0 154 483      EP-A- 0 188 206
AU-B- 18 897        DE-A- 3 020 815
US-A- 4 262 035      US-A- 4 399 014
US-A- 4 461 783

(73) Patentinhaber: **Nukem GmbH**
**Industriestrasse 13**
**W-8755 Alzenau(DE)**

(72) Erfinder: **Von Campe, Hilmar**
**Jakob-Langfelder-Strasse 19**
**W-6380 Bad Homburg(DE)**
Erfinder: **Liedtke, Dietmar**
**Wehrstrasse 14**
**W-6369 Nidderau 4(DE)**
Erfinder: **Schum, Berthold**
**Bornweg 44**
**W-6465 Biebergemünd(DE)**
Erfinder: **Wörner, Jörg**
**Philipp-Reis-Strasse 16**
**W-6451 Grosskrotzenburg(DE)**

(74) Vertreter: **Stoffregen, Hans-Herbert, Dr.**
**Dipl.-Phys. et al**
**Patentanwälte Strasse & Stoffregen Salz-**
**strasse 11a Postfach 2144**
**W-6450 Hanau/Main 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 257 620 B1

**Beschreibung**

Die Erfindung bezieht sich auf ein Verfahren und eine Vorrichtung zum Ausbilden von zumindest einer großflächigen Schicht auf einer Fläche eines Substrats durch plasmachemischen Prozeß gemäß der Oberbegriffe der nebengeordneten Ansprüche 1 und 6.

Plasmachemische Prozesse werden z. B. bei der Herstellung von Solarzellen eingesetzt, wobei unter Ausbilden sowohl das Abscheiden einer Schicht als auch das Abtragen und Behandeln unter Ablauf einer chemischen Reaktion in einer Plasmaentladung zu verstehen ist. Letzteres ist z. B. aus der DE-A 21 52 895 bekannt, bei der der Wirkungsgrad einer Dünnschicht-Solarzelle des Typs Kupfersulfid-Cadmiumsulfid dadurch erhöht wird, daß auf die Kupfersulfidschicht eine weitere Kupfer enthaltende Schicht aufgetragen wird, die dünn gegenüber der Kupfersulfidschicht ist. Dabei kann das Kupferinventar auf die zusätzliche Schicht durch Reduktion des Kupfersulfids an der Oberfläche erzeugt werden, und zwar durch Behandlung im Glimmfeld in einer Wasserstoffatmosphäre. Das Abscheiden von Schichten zur Herstellung von funktionstüchtigen Solarzellen ist z. B. im Zusammenhang mit Inversionsschicht-Solarzellen bekannt. Glimmprozesse werden aber auch z. B. bei der Reinigung von Reaktionsräumen eingesetzt, die zur Herstellung von a-Si-Solarzellen benutzt werden. Hierbei dient die Glimmentladung dazu, in dem Reaktionsraum z. B. vorhandenes Polysilan oder Polymere der Dotiergase durch Wegätzen zu reinigen.

Bei plasmachemischen Prozessen zur Abscheidung von z. B. amorphen Siliziumschichten werden konventionelle Elektrodengeometrien eingesetzt. Dies bedeutet, daß zwei gegenüberliegende Elektrodenplatten verwendet werden. Hierbei wird zwar ein homogenes elektrisches Feld erzeugt, jedoch entstehen Probleme bei der Gaszuführung, sofern das Gas von der Seite eingeführt wird. Ein solcher Nachteil ist insbesondere dann gegeben, wenn große Flächen beschichtet werden sollen. Bei hohen Abscheideraten tritt nämlich eine Verarmung des Gasgemisches an $SiH_4$ und Dotiergasen wie z. B. $B_2H_6$ oder $PH_3$ mit der Folge einer ungleichmäßigen Schichtdicke bzw. Dotierung ein.

Ein weiterer Nachteil einer solchen Elektrodenanordnung ist darin zu sehen, daß die Schicht während ihres Wachstums durch Beschuß mit geladenen Teilchen, also Ionen oder Elektronen in ihrer Qualität beeinträchtigt wird.

In diesem Zusammenhang ist eine Anordnung zur Abscheidung amorpher Siliziumschichten bekannt, bei denen die zu beschichtende Substratfläche nicht zwischen zwei gegenüberliegenden Plattenelektroden, sondern seitlich außerhalb der Platten angeordnet ist, in der Absicht, daß sich das ausbildende elektrische Feld nach Möglichkeit parallel zur Substratoberfläche zeigt.

Ein Nachteil einer solchen Anordnung ist jedoch, daß in der Plattenkondensatoranordnung naturgemäß ein homogenes Feld nur zwischen den Platten zu verwirklichen ist, und zwar, wenn diese dicht genug beieinanderstehen, was die Beschichtung großer Flächen mit Feldkomponenten parallel zur Substratfläche grundsätzlich verbietet. Außerhalb des Plattenkondensators ist das Feld inhomogen - besonders an den Kanten - und zudem sehr schwach. Daher ist eine Beschichtung von großflächigen Substraten in dieser Elektrodengeometrie schwierig und uneffektiv (niedrige Silanausbeute), denn erstens bedingt die inhomogene Feldverteilung eine ungleichmäßige Schichtdicke, und zweitens wird die Abscheiderate mit wachsender Entfernung der Platten voneinander sehr klein.

Die Probleme dieser Anordnung liegen also darin begründet, daß die grundsätzliche Überlegung, das parallele elektrische Feld zwischen zwei Platten zu erzeugen, bei großer Entfernung der Platten (Abstand ≪ Plattendurchmesser) nicht mehr stimmt, also gar nicht geeignet ist, große Substrate (ca. 100 $cm^2$ oder mehr) zu beschichten.

Um die Homogenisierung der Abscheiderate dennoch zu verbessern, wird eine dritte Elektrode als Hilfselektrode eingeführt, die parallel zum elektrischen Feld verläuft. Zur großflächigen Beschichtung wird dieses Elektrodensystem wiederholt aneinandergereiht, so daß eine Anordnung von Elektroden mit alternierender Polarität entsteht.

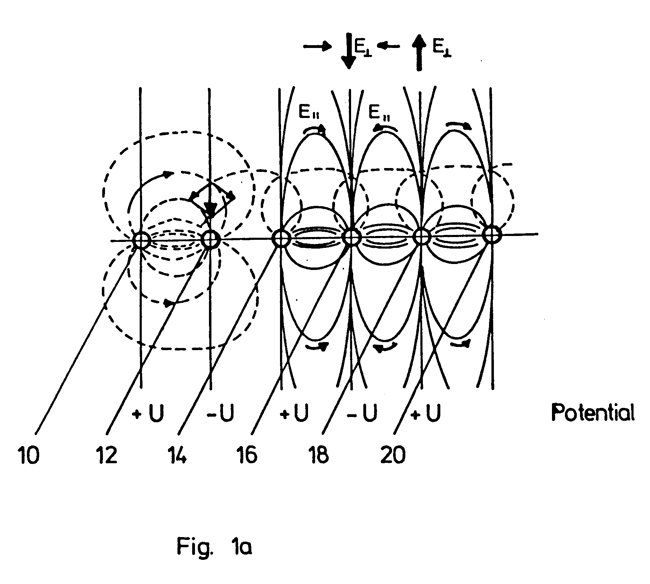

Dies erläutert Fig. 1a. Hier ist ein System aus Stabelektroden (10) bis (20) mit alternierender Polarität dargestellt. Für die oben beschriebene Plattenkondensatoranordnung ergibt sich der gleiche Verlauf des elektrischen Feldes für den Grenzfall, daß der Abstand der Platten groß gegenüber dem Plattendurchmesser wird. Es ist dargestellt, wie sich nach dem Superpositionsprinzip aus den elektrischen Feldlinien eines beliebigen herausgegriffenen Dipols (gestrichelte Linien) bei Vektoraddition der elektrischen Feldbeiträge schließlich der resultierende Feldverlauf (durchgezogene Linien) ergibt. An der Elektrode werden die Feldlinien gebündelt, und es entsteht ein stark inhomogenes, alternierendes elektrisches Feld senkrecht zur gedachten Substratfläche ($E_\perp$). Zwischen den Elektrodenstäben ist das elektrische Feld sehr schwach und parallel zur gedachten Substratfläche ($E_\parallel$)

Die Gleichmäßigkeit der Abscheiderate wird durch "kapazitive Optimierung" des Elektrodenpotentials erreicht. Bei einer entsprechenden Anordnung kann jedoch weiterhin die Gaszufuhr zu Problemen führen. Ferner ist eine Anordnung der Elektroden in bezug auf Substrate, die von einer planen Geometrie abweichen, nicht erwähnt worden.

Ein Verfahren der eingangs genannten Art ist der US-A-4 399 014 zu entnehmen. Dabei wird eine Vielzahl von stabförmigen Elektroden in gleichem Abstand zueinander angeordnet. Die Polarität der Elektroden ist ebenfalls alternierend gewählt. Die zu behandelnde Substratfläche befindet sich sodann zwischen zwei Elektrodensystemen. Dieses Verfahren wird kommerziell zur Oberflächenglimmbehandlung von Leiterplatten aus Kunststoff eingesetzt. Der bei dieser Anordnung erreichte starke Beschuß der Oberfläche mit Ionen ist eine Folge der Richtung des beschleunigenden elektrischen Feldes senkrecht zur Substratoberfläche. Als Folge des Teilchenbeschusses erreicht man eine Reinigung der Oberfläche sowie bessere Hafteigenschaften durch Aufbrechen chemischer Bindungen. Im Fall der Schichtherstellung jedoch ist dieser Effekt unerwünscht; denn, wenn das elektrische Feld senkrecht zur Substratoberfläche zeigt, so daß Ionen und Elektronen unmittelbar in die wachsende Schicht einschlagen können, tritt eine Verschlechterung der Substratoberfläche ein, so daß ein entsprechendes Herstellungsverfahren insbesondere bei Dünnschichtsolarzellen wie a-Si-Zellen nachteilhaft ist. Ferner ist das elektrische Feld aufbaubedingt inhomogen (siehe Fig. 1a), so daß als Folge davon ebenfalls eine negative Beeinflussung der Abscheiderate gegeben ist.

Aufgabe der vorliegenden Erfindung ist es, ein Verfahren und eine Vorrichtung der eingangs genannten Art vom physikalischen Prinzip her so auszubilden, daß problemlos große Flächen beschichtet werden können, daß die Abscheiderate homogen ist, daß das elektrische Feld parallel zur zu behandelnden Fläche des Substrats ausgerichtet ist und daß eine homogene Gaszuführung erzielt werden kann.

Die Aufgabe wird erfindungsgemäß durch ein Verfahren gelöst, das sich dadurch auszeichnet, daß die Fläche vollständig oder nahezu vollständig parallel zu dem elektrischen Feld ausgerichtet wird, daß das zur Ausbildung der Schicht erforderliche Gas zwischen den und/oder durch die Elektroden unmittelbar auf die Fläche strömt und daß das Potential von aufeinanderfolgenden Elektroden gleichmäßig ansteigt.

Durch die erfindungsgemäße Lehre wird eine plasmaunterstützte Beschichtung und Oberflächenbehandlung von insbesondere großflächigen, nicht notwendigerweise ebenen Substratflächen und Formkörpern ermöglicht, wobei deren Geometrie hinsichtlich der zu behandelnden Fläche nicht notwendigerweise plan ausgebildet sein muß. Insbesondere eignet sich die erfindungsgemäße Lehre dazu, großflächige Dünnschichtsolarzellen, insbesondere a-Si-Solarzellen der Größe von z. B. 30 x 30 cm² herzustellen, ohne daß eine Inhomogenität hinsichtlich der Abscheiderate oder einer Oberflächenbeschädigung durch auftreffende Ionen gegeben ist. Dabei kann eine nahezu beliebige Vergrößerung der Fläche erfolgen, ohne daß prinzipielle Änderungen erfolgen müssen. Grenzen sind selbstverständlich apparativ gesetzt.

Durch die erfindungemäße Lehre ergibt sich des weiteren der Vorteil, daß ein gezielter Materialtransport an die Substratfläche gewährleistet ist, so daß eine hohe Ausnutzung der Reaktionsgasmenge erfolgt.

Um z. B. auch die Oberfläche von z. B. zylinderförmigen Körpern oder anderen Geometrien nach dem erfindungsgemäßen Verfahren plasmatechnisch behandeln zu können, wird nach einer Ausgestaltung der Erfindung vorgeschlagen, daß die Flächen im wesentlichen parallel zu den von den Elektroden aufgespannten Umhüllenden ausgerichtet wird. Mit anderen Worten braucht die Elektrodenanordnung nur entsprechend dem geometrischen Verlauf der zu behandelnden Oberfläche angeordnet zu werden, um diese durch Plasmaentladung zu reinigen und/oder eine Schicht aufzutragen.

Dabei kann bei der Verwendung von z. B. Ringelektroden, die koaxial zu dem Substrat angeordnet sind, eine plasmachemische Behandlung auch im Durchlaufverfahren erfolgen, d. h., das Substrat kann entlang der durch die Ringelektrode vorgegebenen Hauptachse verschoben werden.

Eine Vorrichtung zur Ausbildung einer großflächigen Schicht auf einer Fläche eines Substrats durch plasmachemischen Prozeß nach dem Oberbegriff des Anspruchs 6 zeichnet sich dadurch aus, daß die Vorrichtung zumindest drei Elektroden umfaßt, wobei das Potential von aufeinanderfolgenden Elektroden gleichmäßig ansteigt, daß die Elektroden eine Umhüllende bilden, die dem Verlauf des zwischen den Elektroden sich ausbildenden elektrischen Feldes entspricht und parallel oder nahezu parallel zu der Fläche des Substrats verläuft, und daß das zur Ausbildung der Schicht erforderliche Gas zwischen den und/oder durch die Elektroden strömt.

Dabei ist in Ausgestaltung der Erfindung die Elektrode hohlzylinderförmig ausgebildet und weist Austrittsöffnungen für durch die Elektroden strömendes Gas auf. Hierdurch wird der Vorteil erzielt, daß das Gas unmittelbar auf und gleichmäßig über die zu behandelnde Fläche abgegeben wird, so daß eine überaus homogene Abscheiderate erzielbar ist. Dadurch, daß die Elektroden in einer gedachten Fläche angeordnet sind, die in etwa parallel zur behandelnden Fläche des Substrats verlaufen, ist gewährleistet, daß das sich zwischen den Elektroden ausbildende elektrische Feld parallel zur zu behandelnden Fläche verläuft. Hierdurch unterbleibt ein Ionenbeschuß der Fläche und somit eine negative Beeinflussung der durch den plasmachemischen Prozeß ausgebildeten Schicht.

Weitere Einzelheiten, Vorteile und Merkmale der Erfindung ergeben sich nicht nur aus den Ansprüchen, den diesen zu entnehmenden Merkmalen - einzeln und/oder in Kombination -, sondern auch aus der nachfolgenden Beschreibung von in der Zeichnung dargestellten bevorzugten Ausführungsbeispielen.

Es zeigen:

Fig. 1a   eine Feldlinienverteilung eines elektrischen Feldes nach dem Stand der Technik,

Fig. 1b   eine Feldlinienverteilung eines erfindungsgemäß aufgebauten elektrischen Feldes,

Fig. 2   eine entsprechende Feldlinienverteilung durch Influenz,

Fig. 3   eine Anordnung von Elektroden zur Beschichtung eines Formkörpers,

Fig. 4   die Verschaltung der Elektroden nach Fig. 3 und

Fig. 5   Elektroden mit Gaszuführung,

Fig. 6   eine weitere Ausführungsform der Anordnung von Elektroden und

Fig. 7   eine weitere Ausführungsform einer Elektrodenanordnung.

In Fig. 1a ist eine Feldlinienverteilung eines elektrischen Feldes dargestellt, das zwischen Elektroden verläuft, die an alternierende Potentiale gelegt sind, also einer Anordnung gehorchen, wie sie z. B. der US-A-4 399 014 zu entnehmen ist. Nachteil dieser Anordnung ist, daß die Oberfläche eines zu behandelnden Substrats mit geladenen Teilchen bombardiert wird, wodurch eine Beschädigung erfolgen kann. Erfindungsgemäß soll von der dem Stand der Technik zu entnehmenden alternierenden Polarität grundsätzlich abgewichen werden, um problemlos große Flächen von 30 cm$^2$, vorzugsweise 100 cm$^2$ oder mehr behandeln zu können.

In einem nicht dargestellten Reaktionsraum wie Plasmareaktor befinden sich Substrat, Substratheizung, Elektrodensystem sowie Gaszuführung. In einem solchen Reaktionsraum soll nun eine Fläche des Substrats behandelt werden, d. h. auf einer Fläche soll z. B. eine Schicht aufgetragen oder z. B. gereinigt werden. Anwendungsfälle sind z. B. in der Solartechnik die Herstellung von Dünnschichtsolarzellen aus amorphem Silizium. Aber auch Werkstückbeschichtungen zur Oberflächenvergütung durch z. B. metallische Werkstoffe, Oxide, Nitride oder Karbide sind Anwendungsfälle der vorliegenden Erfindung, ohne daß hierdurch eine Beschränkung erfolgen soll.

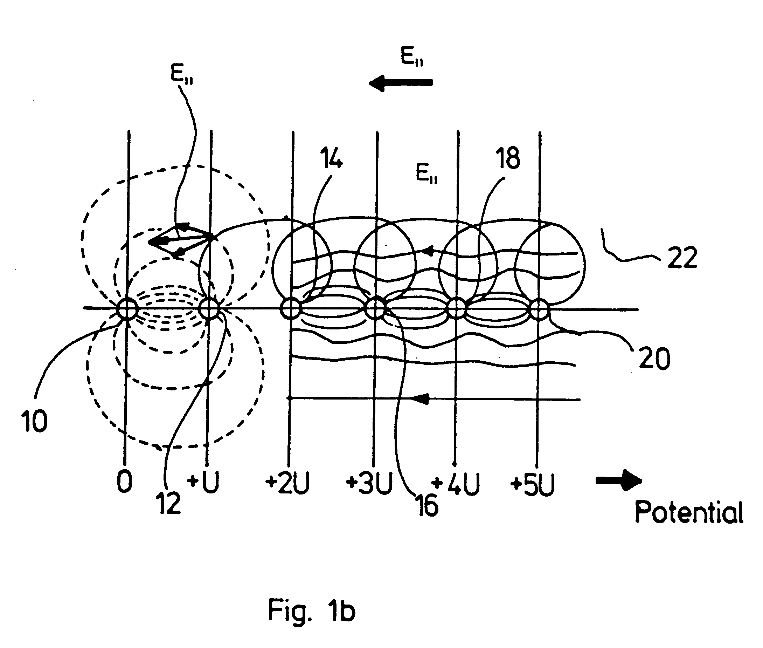

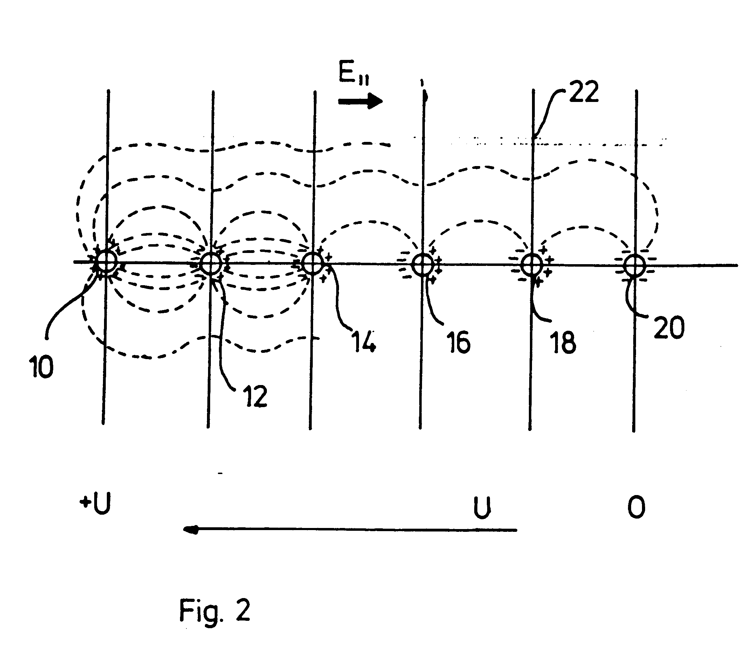

Das Elektrodensystem selbst besteht im Ausführungsbeispiel der Fig. 1b und 2 aus mehreren parallel angeordneten zylinder- oder rohrförmigen Leiterstäben (10), (12), (14), (16), (18) oder (20). Das Substrat (22) befindet sich im Abstand von einigen Zentimetern zu den Elektroden (10) bis (20). Durch eine Hochfrequenzwechselspannung erfolgt sodann nach Zuführung eines Gases die Plasma- oder Glimmentladung. Selbstverständlich kann die Hochfrequenzspannungsquelle auch durch eine Gleichspannungsquelle ersetzt werden.

Die einzelnen Elektroden (10) bis (20) werden dabei so verschaltet, daß das elektrische Feld der Entladung parallel zur Substratoberfläche gerichtet ist. Betrachten wir in Fig. 1b zu einem festen Zeitpunkt die Potentiale der Elektroden (10) bis (20), dann wird die dargestellte Feldverteilung nach dem Superpositionsprinzip dann erreicht, wenn zwei benachbarte Elektroden die gleiche Potentialdifferenz $\phi_i - \phi_{i-1} = u$ besitzen. Da während der gesamten Periode $\phi_i - \phi_{i-1}$ für alle Elektroden (10) bis (20) gleichgroß sein soll, muß im Falle der HF-Entladung auf die Phasenlage geachtet werden. Dazu sind geeignete RC-Glieder vorgesehen. Im Ausführungsbeispiel ist das Potential gleichmäßig ansteigend, wie durch die Abzissenwerte 0, u, 2u ... verdeutlicht wird.

Eine entsprechende Feldverteilung für zumindest niedrige Frequenzen läßt sich auch durch Ausnutzung der Influenz erreichen, wie anhand der Fig. 2 verdeutlicht werden soll. Man erkennt ebenfalls die mit gleichen Bezugszeichen versehenen Elektroden (10) bis (20) sowie die Erzeugung des elektrischen Feldes durch Influenz, wobei die äußersten Elektroden (10) und (20) an das Potential 0 bzw. +u angelegt sind.

Man erkennt aus dem Feldlinienverlauf, daß in gewisser Entfernung zu dem Elektrodensystem das elektrische Feld homogen wird. Ferner ist es parallel zu der zu beschichtenden Substratfläche ausgerichtet, so daß die Elektronen und Ionen horizontal beschleunigt werden und nicht auf die Substratoberfläche auftreffen können. Ein Bombardement durch Ionen auf die auszubildende Schicht ist dadurch ausgeschlossen. Dies ist insbesondere für die Herstellung amorpher Siliziumschichten für großflächige Dünnschichtsolarzellen von Vorteil. Die zuvor beschriebene Verschaltung der Elektroden (10) bis (20) ermöglicht aber auch eine großflächige Beschichtung von Substraten mit anderen Materialien. Aufgrund der Homogenität des Feldes in der Substratebene ist die Abscheiderate überaus gleichmäßig.

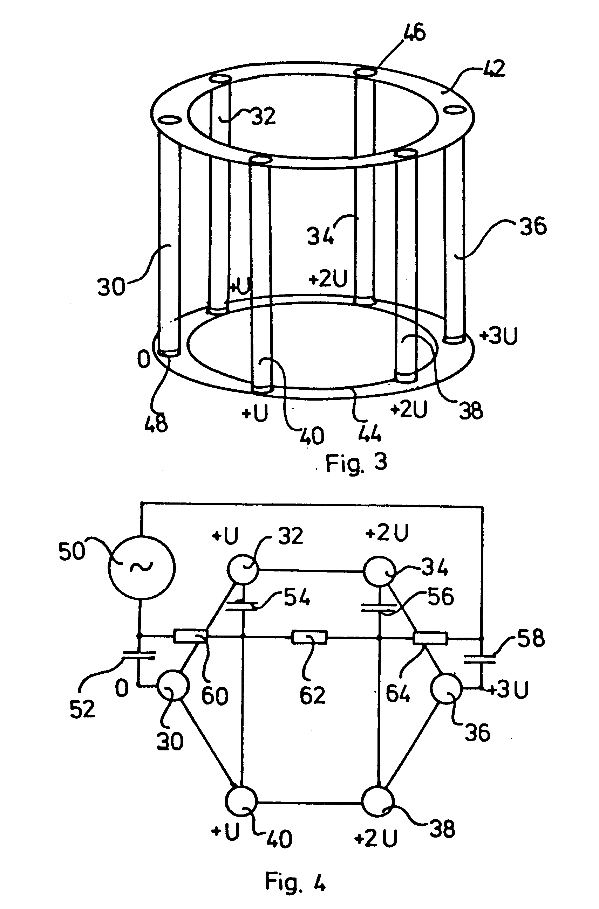

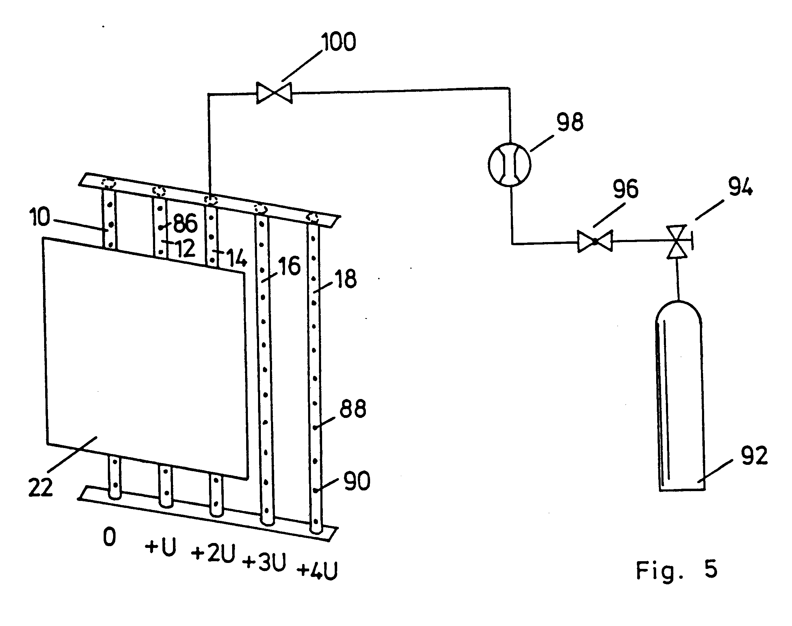

Ferner ermöglicht es die erfindungsgemäße Ausbildung der Elektroden und deren Zuordnung zueinander, daß das für den plasmachemischen Prozeß erforderliche Gas die zu behandelnde Fläche gleichmäßig überstreichen kann. Es ist eine direkte Anströmung des Substrats senkrecht zu der zu behandelnden Oberfläche möglich. Vorteilhafterweise kann bei der Ausführung von Elektroden (10) bis (20) als Hohlzylinderrohre das Gas ohne Zersetzung in den Innenräumen der Rohre geführt werden, um über Aussparungen wie Schlitze oder Bohrungen (86), (88), (90) unmittelbar auf das Substrat (22) zu gelangen. Dies ist in Fig. 5 angedeutet. Das Gas wird dabei von einer Quelle (92) wie Gasflasche über Ventile (94), (96) und einem Durchflußmeßgerät (98) den Elektroden (10) bis (18) zugeführt, wobei die Verbindung innerhalb des Reaktionsraumes über einen Schnellverschluß (100) erfolgen kann, was im Falle der Formkörperbeschichtung einen schnellen Austausch geeigneter Elektrodensysteme (nach Fig. 4 - 6) erlauben würde.

Das Gasführungssystem ist demzufolge in den Elektroden (10) bis (20) integriert, wobei dieses mit dem Schnellverschluß (100) als aufsteckbares Modul ausgeführt sein kann. Eine entsprechende Gaszuführung bietet gegenüber herkömmlichen Anordnungen insbesondere die Vorteile, daß die zu behandelnden Flächen direkt von vorne angeströmt werden können. Durch die gleichmäßige Anströmung wird demzufolge die Abscheiderate überaus homogen. Durch die Führung des Gases innerhalb der Elektroden (10) bis (18) gelangt das Gas völlig unzersetzt unmittelbar zu der Substratoberfläche. Verbrauchtes Gas kann unmittelbar abgeführt werden, so daß sich ein stationärer Zustand zwischen der Zuführung von frischen und der Entfernung von verbrauchten Gas in kurzer Zeit einstellt. Demzufolge sind Langzeitveränderungen der Reaktionsatmosphäre durch Anreicherung verbrauchter Bestandteile ausgeschlossen.

Um einen etwaigen Druckabfall innerhalb der Elektroden beim ausströmenden Gas nicht wirksam werden zu lassen, kann die Größe der Aussparungen und/oder deren Abstand entlang einer jeden Elektrode variiert werden.

Anhand der Fig. 3, 4 und 6 sollen besondere Ausführungsformen von Elektrodenanordnungen verdeutlicht werden. In Fig. 4 sind stabförmige Elektroden (30), (32), (34), (36), (38), (40) auf einem Zylindermantel angeordnet, um insbesondere Rohre von innen oder außen oder andere Formkörper zu beschichten. Die Anordnung der Elektroden (30) bis (40) ist dabei der Geometrie der zu behandelnden Fläche des Substrats angepaßt. Dabei können auch die Innenflächen eines Hohlkörpers beschichtet werden. Um das Substrat im erforderlichen Umfang aufzuheizen, bedarf es hierbei keiner unmittelbaren Verbindung mit einem Heizkörper. Vielmehr kann das Aufheizen durch Strahlung oder Stromflußaufheizung des Substrates selbst erreicht werden.

Die Elektroden (30) bis (40) sind dabei an den Stirnseiten isolierend von Trägerringen (42), (44) aufgenommen. Dies kann über Isolationsringe erfolgen, die beispielhaft mit den Bezugszeichen (46) und (48) versehen sind.

Die elektrische Verschaltung der Elektroden (30) bis (40) erfolgt entsprechend der Darstellung nach Fig. 4. Man erkennt, daß als Spannungsquelle (50) eine Hochfrequenzwechselspannung benutzt wird, die über aus Kondensatoren (52), (54), (56), (58) und Widerständen (60), (62), (64) gebildete RC-Glieder mit den Elektroden (30) bis (40) verbunden sind, um zwischen aufeinanderfolgenden Elektroden eine gleiche Potentialdifferenz zu erzielen. Dies ist dadurch angedeutet, daß die Elektroden mit Potentialen $\phi_0 = 0$, $\phi_1 = u$, $\phi_2 = 2u$ und $\phi_3 = 3u$ vesehen sind, wobei die Differenz zwischen $\phi_0$ und $\phi_1$ und $\phi_1$ und $\phi_2$ bzw. $\phi_2$ und $\phi_3$ jeweils gleichgroß ist, wobei in bezug auf die Randelektrode (38) das Potential zu den folgenden Elektroden (36) bzw. (40) und (34) bzw. (30) und (32) kontinuierlich ansteigt.

Ausgehend von der Elektrode (38) nimmt demzufolge zu beiden Seiten des Ringes, auf dem die Elektroden (30) bis (40) angeordnet sind, das Potential zu. Parallel zu diesem Ring, also zu den Trägerringen (42), (44) richtet sich nach dem Superpositionsprinzip das elektrische Feld zwischen den Elektroden (30) bis (40) aus, so daß problemlos ein Formkörper durch plasmachemischen Prozeß behandelt werden kann.

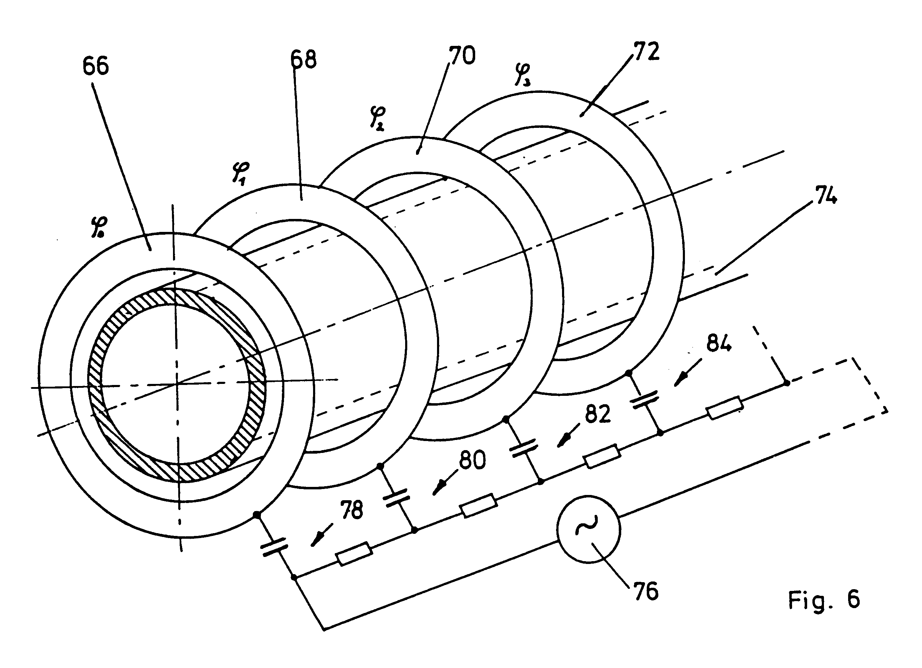

In Fig. 6 ist eine alternative Anordnung von Elektroden (66), (68), (70), (72) dargestellt, durch die ebenfalls ein Formkörper wie Rohr (74) behandelt insbesondere beschichtet werden soll. Bei den Elektroden (66) bis (72) handelt es sich um Ringelekroden, die koaxial zu dem zu beschichtenden Rohr (74) angeordnet sind. Die Elektroden (66) bis (72) sind ebenfalls an eine Hochfrequenzspannungsquelle (76) über RC-Glieder (78), (80), (82), (84) verschaltet, um von Elektrode zu Elektrode, also zwischen den Elektroden (66), (68) bzw. (68), (70) bzw. (70), (72) nicht nur eine gleiche Potentialdifferenz, sondern auch ein kontinuierlich einsteigendes Potential einzustellen.

Sofern die Elektrode nicht in einer planen Ebene sondern z. B. auf einem Zylindermantel (Fig. 3) angeordnet und/oder als Ringelektroden (Fig. 6) ausgebildet sind, kann ggf. auch eine Verschaltung mit alternierender Polarität gewählt werden, ohne notwendigerweise die durch die Erfindung erzielten Vorteile zu verlassen.

Ferner besteht die Möglichkeit, daß die zu behandelnden Objekte bei der Anordnung nach Fig. 3 um die Symmetrieachse gedreht oder bei der Ausführungsform nach Fig. 6 in Richtung der Symmetrieachse transportiert werden können, so daß ein plasmachemischer Prozeß im Durchlaufverfahren gegeben ist.

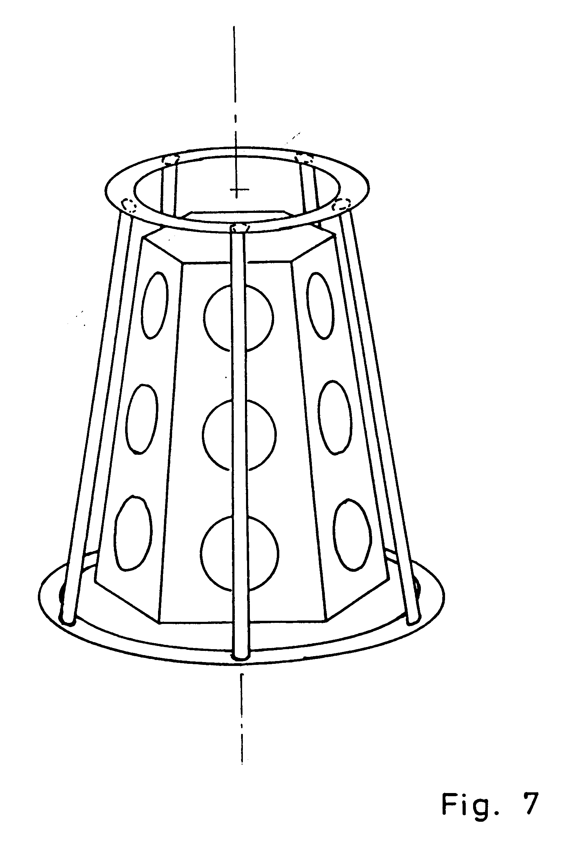

Sofern eine Anordnung nach Fig. 4 für nicht zylindersymmetrische Formkörper Verwendung finden soll, kann das elektrische Feld durch Veränderung des Abstandes der Stabelektroden, wie in Fig. 7 gezeigt ist, um die Substratfläche an die Umhüllende des Formkörpers angepaßt werden.

Es ist auch möglich, durch eine Änderung des Abstandes von Ring zu Ring oder durch eine Anpassung des Elektrodenpotentials über RC-Glieder, die von dem elektrischen Feld gebildete Umhüllende an die des Formkörpers anzupassen.

Die Elektroden selbst können in selbsttragender Ausführungsform (Fig. 6) oder an isolierenden Trägern (Fig. 3) befestigt sein. Auch besteht die Möglichkeit, Leiterbahn oder Drähte auf der Außen- und/oder Innenfläche eines Rohres, an der Oberfläche einer Platte oder einer anderen (der geometrischen Form des zu beschichtenden Körpers anzupassenden) Fläche anzuordnen, um die erfindungsgemäße Lehre zu realisieren.

**Patentansprüche**

1. Verfahren zum Ausbilden von zumindest einer großflächigen Schicht auf einer Fläche eines Substrats (22) durch plasmachemischen Prozeß unter Verwendung von zumindest drei vorzugsweise an eine Hochfrequenzspannungsquelle angelegten, in einem evakuierbaren und mit Gas beschickbaren Reaktionsraum angeordneten Elektroden (10, 12, 14, 16, 18, 20, 30, 32, 34, 36, 38, 40, 66, 68, 70, 72), zwischen denen ein elektrisches Feld ausgebildet ist, zu dem seinerseits die Fläche ausgerichtet wird,
   **dadurch gekennzeichnet,**
   daß die Fläche vollständig oder nahezu vollständig parallel zu dem elektrischen Feld ausgerichtet wird, daß das zur Ausbildung der Schicht erforderliche Gas zwischen den und/oder durch die Elektroden (10, 12, 14, 16, 18) unmittelbar auf die Fläche strömt und daß das Potential von aufeinanderfolgenden Elektroden gleichmäßig ansteigt.

2. Verfahren nach Anspruch 1,
   **dadurch gekennzeichnet,**
   daß die Fläche im wesentlichen parallel zu einer von den Elektroden (10, 12, 14, 16, 18, 20, 30, 32, 34, 36, 38, 40, 66, 68, 70, 72) aufgespannten Ümhüllenden ausgerichtet wird.

3. Verfahren nach Anspruch 1,
   **dadurch gekennzeichnet,**
   daß das elektrische Feld an die Fläche durch Veränderung des Abstandes die Elektroden (10, 12, 14, 16, 18, 20, 30, 32, 34, 36, 38, 40, 66, 68, 70, 72) und/oder durch Variation des Potentials zwischen diesen angepaßt wird.

4. Verfahren nach Anspruch 1,
   **dadurch gekennzeichnet,**
   daß das Substrat (22) vorzugsweise indirekt geheizt wird.

5. Verfahren nach Anspruch 1,
   **dadurch gekennzeichnet,**
   daß das die Fläche aufweisende Substrat (22) während des plasmachemischen Prozesses zwischen den Elektroden (66, 68, 70, 72) hindurchgeführt wird.

6. Vorrichtung zur Durchführung des Verfahrens nach Anspruch 1, zum Ausbilden von zumindest einer großflächigen Schicht auf einer Fläche eines Substrats (22) durch plasmachemischen Prozeß, wobei das Substrat in einem evakuierbaren Reaktionsraum angeordnet ist, in dem mit vorzugsweise einer Hochfrequenzspannungsquelle (50, 76) Zumindest drei verbindbare Elektroden (10, 12, 14, 16, 18, 20, 30, 32, 34, 36, 38, 40, 66, 68, 70, 72) und zumindest eine Zuführung für das für den Prozeß erforderliche Gas angeordnet sind,
   **dadurch gekennzeichnet,**
   daß das Potential von aufeinanderfolgenden Elektroden gleichmäßig ansteigt, daß die Elektroden eine Umhüllende bilden, die dem Verlauf des zwischen den Elektroden sich ausbildenden elektrischen Feldes entspricht und parallel oder nahezu parallel zu der Fläche des Substrats (22) verläuft, und daß das zur Ausbildung der Schicht erforderliche Gas zwischen den und/oder durch die Elektroden (10, 12, 14, 16, 18) strömt.

7. Vorrichtung nach Anspruch 6,
   **dadurch gekennzeichnet,**
   daß die Elektroden (10, 12, 14, 16, 18, 20, 30, 32, 34, 36, 38, 40) hohlzylinderförmig ausgebildet und Austrittsöffnungen (86, 88, 90) für das Gas aufweisen.

8. Vorrichtung nach Anspruch 6,
   **dadurch gekennzeichnet,**
   daß die Elektroden Ringelektroden (66, 68, 70, 72) sind, die koaxial zu dem die Fläche aufweisenden Substrat (74) wie Zylinder angeordnet sind.

9. Vorrichtung nach Anspruch 6,
   **dadurch gekennzeichnet,**
   daß die Elektroden auf der Umfangsfläche eines Zylinders angeordnet sind.

## Claims

1. Method for forming at least one large-area layer on a surface of a substrate (22) by a plasma-chemical process using at least three electrodes (10, 12, 14, 16, 18, 20, 30, 32, 34, 36, 38, 40, 66, 68, 70, 72) connected preferably to a high-frequency voltage source, said electrodes are arranged in an evacuatable reaction chamber which can be filled with gas, between said electrodes an electrical field has been generated, said surface is aligned to said electrical field,
**wherein**
said surface runs completely or almost completely parallel to said electrical field, said gas required for forming of the layer flows directly onto the surface between and/or through the electrodes (10, 12, 14, 16, 18), and the potential rises evenly in consecutive electrodes.

2. Method according to Claim 1,
**wherein**
said surface is aligned substantially parallel to an envelopes created by the electrodes (10, 12, 14, 16, 18, 20, 30, 32, 34, 36, 38, 40, 66, 68, 70, 72).

3. Method according to Claim 1,
**wherein**
the electrical field is adapted to the surface by modifying the distance between the electrodes (10, 12, 14, 16, 18, 20, 30, 32, 34, 36, 38, 40, 66, 68, 70, 72) and/or by varying the potential between them.

4. Method according to Claim 1,
**wherein**
the substrate (22) is preferably indirectly heated.

5. Method according to Claim 1,
**wherein**
the substrate (22) having the surface is guided between the electrodes (66, 68, 70, 72) during the plasma-chemical process.

6. Device for carrying out the method according to Claim 1, for forming at least one large-area layer on a surface of a substrate (22) by means of a plasma-chemical process, said substrate being positioned in an evacuatable reaction chamber in which at least three electrodes (10, 12, 14, 16, 18, 20, 30, 32, 34, 36, 38, 40, 66, 68, 70, 72) connectable preferably to a high-frequency voltage source (50, 76) and at least one feed for the gas required by the process are arranged,

**wherein**
the potential of said electrodes in sequence increases evenly, said electrodes are positioned to form an envelope corresponding to the pattern of the electrical field generated between said electrodes and running parallel or nearly parallel to the surface of the substrate (22), and said gas required for generating the layer flows between and/or through the electrodes (10, 12, 14, 16, 18).

7. Device according to Claim 6,
**wherein,**
said electrodes (10, 12, 14, 16, 18, 20, 30, 32, 34, 36, 38, 40) are in the shape of hollow cylinders and said electrodes have outlets (86, 88, 90) for the gas.

8. Device according to Claim 6,
the electrodes are ring electrodes (66, 68, 70, 72) which are positioned co-axially to the substrate (74) having the surface and arranged like a cylinder.

9. Device according to Claim 6,
the electrodes are positioned on the peripheral surface of a cylinder.

## Revendications

1. Procédé pour former au moins une couche de grande surface sur une surface d'un substrat (22) par un procédé de chimie au plasma en utilisant au moins trois électrodes (10, 12, 14, 16, 18, 20, 30, 32, 34, 36, 38, 40, 66, 68, 70, 72) reliées de préférence à une source de tension à haute fréquence, ces électrodes placées dans la chambre de réaction sous vide, susceptible de recevoir un gaz, développant entre elles un champ électrique vers lequel est dirigée la surface,
procédé caractérisé en ce que la surface est alignée totalement ou pratiquement totalement parallèlement au champ électrique, et en ce que le gaz nécessaire pour former la couche passe erre les et/ou à travers les électrodes (10, 12, 14, 16, 18), pour arriver directement sur la surface et en ce que le potentiel augmente régulièrement d'une électrode à l'électrode suivante.

2. Procédé selon la revendication 1, caractérisé en ce que la surface est pour l'essentiel parallèle à l'une des enveloppes sous-tendues par les électrodes (10, 12, 14, 16, 18, 20, 30, 32, 34, 36, 38, 40, 66, 68, 70, 72).

3. Procédé selon la revendication 1, caractérisé en ce que le champ électrique est adapté à la surface par modification de l'écartement des électrodes (10, 12, 14, 16, 18, 20, 30, 32, 34, 36, 38, 40, 66, 68, 70, 72) et/ou par variation du potentiel entre ces électrodes.

4. Procédé selon selon la revendication 1, caractérisé en ce que le substrat (22) est chauffé de préférence de manière indirecte.

5. Procédé selon la revendication 1, caractérisé en ce que le substrat (22) de la surface passe entre les électrodes (66, 68, 70, 72) pendant la mise en oeuvre du procédé de chimie au plasma.

6. Dispositif pour la mise en oeuvre du procédé selon la revendication 1, pour former au moins une couche de grande surface sur une surface d'un substrat (22) par la mise en oeuvre d'un procédé de chimie au plasma, le substrat étant placé dans une chambre de réaction mise sous vide, avec au moins trois électrodes (10, 12, 14, 16, 18, 20, 30, 32, 34, 36, 38, 40, 66, 68, 70, 72) reliées de préférence a une source de tension à haute fréquence (50, 76), et au moins une alimentation du gaz nécessaire à la mise en oeuvre du procédé, dispositif caractérisé en ce que le potentiel des électrodes successives augmente régulièrement, les électrodes forment une enveloppe qui correspond au tracé du champ électrique développé entre les électrodes et est parallèle ou pratiquement parallèle à la surface du substrat (22) et en ce que le gaz nécessaire à la formation de la couche passe entre les électrodes et/ou à travers les électrodes (10, 12, 14, 16, 18).

7. Dispositif selon la revendication 6, caractérisé en ce que les électrodes (10, 12, 14, 16, 18, 20, 30, 32, 34, 36, 38, 40) sont en forme de cylindres creux et comportent des orifices de sortie (86, 88, 90) pour le gaz.

8. Dispositif selon la revendication 6, caractérisé en ce que les électrodes sont des électrodes annulaires (66, 68, 70, 72) disposées coaxialement, comme un cylindre par rapport au substrat (74) ayant la surface à traiter.

9. Dispositif selon la revendication 6, caractérisé en ce que les électrodes sont prévues à la surface d'un cylindre.

Fig. 1a

Fig. 1b

Fig. 2

EP 0 257 620 B1

Fig. 3

Fig. 4

Fig. 5

Fig. 6

EP 0 257 620 B1

Fig. 7